# EUROPÄISCHE PATENTANMELDUNG

(11) **EP 4 814 165 A1**
(43) Veröffentlichungstag der Anmeldung: **30.09.2026**
(21) Anmeldenummer: 25166563.4
(22) Anmeldetag: 27.03.2025
(51) Int. Cl.: C25B 1/34, C25B 11/093, C25B 11/077, C23C 14/08, C23C 14/16, C25D 5/50

(54) **SCHICHTVERBUND, ANODE UND VERFAHREN ZUR HERSTELLUNG EINES SCHICHTVERBUNDS**

(71) Anmelder: Forschungszentrum Jülich GmbH, 52425 Jülich (DE)
(72) Erfinder: Schalenbach, Maximilian, 50739 Köln (DE); Tempel, Hermann, 52372 Kreuzau (DE); Eichel, Rüdiger-A., 52428 Jülich (DE); Appel, Robert, 52349 Düren (DE)
(74) Vertreter: Paul & Albrecht Patentanwälte PartG mbB

(57) **Zusammenfassung**

Die vorliegende Erfindung betrifft einen Schichtverbund (12) umfassend eine elektrisch leitende erste Schicht (13), die zumindest eine elektrisch leitende Metallkomponente aufweist oder aus dieser besteht, insbesondere Titan, und eine die erste Schicht (13) bedeckende, zumindest ein Element der Platinmetallgruppe aufweisende Oxidschicht (16), dadurch gekennzeichnet, dass die Oxidschicht (16) insbesondere fluiddicht ausgebildet ist und elektrisch leitfähige Bereiche aus kristallographischen Rutil-Oxidphasen aufweist, wobei die elektrisch leitfähigen Bereiche Titan als hauptsächlich vorliegende Metallkomponente mit Dotierungen von zumindest einem Platinmetallgruppenmetall, insbesondere Ruthenium und/oder Iridium, sowie Kristallite der Platinmetallgruppenmetall-Oxide umfasst.

## Beschreibung

Die Erfindung betrifft einen Schichtverbund umfassend eine elektrisch leitende erste Schicht, die zumindest eine elektrisch leitende Metallkomponente aufweist oder aus dieser besteht, insbesondere Titan, und eine die erste Schicht bedeckende, zumindest ein Element der Platinmetallgruppe aufweisende Oxidschicht. Ferner betrifft die Erfindung eine Anode für elektrochemische Oxidationsprozesse mit einem solchen Schichtverbund und ein Verfahren zur Herstellung eines solchen Schichtverbunds.

Ruthenium-Titan-Oxidschichten sind für ihre Leitfähigkeit, Korrosionsbeständigkeit und katalytische Aktivität in Bezug auf die Chlorentwicklungsreaktion (CER) bekannt. Dieses Mischmetalloxid wird, als Beschichtung aufgetragen auf eine elektrisch leitende erste Schicht, bei der es sich normalerweise um eine Titanschicht handelt, insbesondere in Form einer dimensionsstabilen Anode eingesetzt, die seit über 50 Jahren als Stand der Technik und Industriestandard für die Chloralkali-Elektrolyse gilt. Die Beschichtung für eine solche Anode wird in der Regel durch wiederholtes Auftragen und Kalzinieren einer Lösung der Metallsalze aufgebracht. Nachteilig ist jedoch, dass die Salzsynthese zu einer porösen und grabenreichen Struktur führt, die auch als sogenannte "Schlammrissoberfläche" bezeichnet wird und bei der CER durchlässig für den Elektrolyten ist. Um die Oxidationsrate der Titanschicht unter der die bedeckenden Ruthenium-Titan-Oxidschicht zu reduzieren, werden Ruthenium-Titan-Oxidschichten mit großer Schichtdicke erzeugt. Große Schichtdicken ziehen einen hohen Rutheniumverbrauch nach sich, was als nachteilig angesehen wird. Weiterhin ist es mit dieser Beschichtung nicht möglich, die Titanschicht vollständig zu schützen, wodurch die Langlebigkeit des Schichtverbunds beeinträchtigt werden kann. Wenn der Schichtverbund auf eine Temperatur oberhalb von 600°C erhitzt wird, oxidiert die die Titanschicht, da Sauerstoff ungehindert durch die Porösität der Ruthenium-Titan-Oxidschicht an die Titanschicht gelangt. Daraufhin kommt es zu einer Titanoxid-Zwischenschicht zwischen der Titanschicht und der Ruthenium-Titan-Oxidschicht, die einen sehr hohen elektrischen Widerstand aufweist, der nachteilig für die Elektrolyse ist.

Ausgehend von diesem Stand der Technik ist es eine Aufgabe der vorliegenden Erfindung, einen verbesserten Schichtverbund der eingangs genannten Art, eine verbesserte Anode mit einem solchen Schichtverbund sowie ein verbessertes Verfahren zur Herstellung eines Schichtverbunds der eingangs genannten Art zu schaffen.

Zur Lösung dieser Aufgabe schafft die vorliegende Erfindung einen Schichtverbund umfassend eine elektrisch leitende erste Schicht, die zumindest eine elektrisch leitende Metallkomponente aufweist oder aus dieser besteht, insbesondere Titan, und eine die erste Schicht bedeckende, zumindest ein Element der Platinmetallgruppe aufweisende Oxidschicht, dadurch gekennzeichnet, dass die Oxidschicht insbesondere fluiddicht ausgebildet ist und elektrisch leitfähige Bereiche aus kristallographischen Rutil-Oxidphasen aufweist, wobei die elektrisch leitfähigen Bereiche Titan als hauptsächlich vorliegende Metallkomponente mit Dotierungen von zumindest einem Platinmetallgruppenmetall, insbesondere Ruthenium und/oder Iridium, sowie Kristallite der Platinmetallgruppenmetall-Oxide umfasst. Dank der erfindungsgemäßen Struktur der Oxidschicht lässt sich eine Korrosion der ersten Schicht, beispielsweise durch einen Elektrolyten bei der Chloralkali-Elektrolyse, sicher verhindern, was wiederum eine lange Lebensdauer nach sich zieht. Damit kann für die Oxidschicht eine deutlich geringere Schichtdicke gewählt werden, als es bei der eingangs beschriebenen Herstellung mittels Salzsynthese möglich ist. Entsprechend kann auch der Gehalt des zumindest einen Elementes aus der Platinmetallgruppe gegenüber dem Stand der Technik reduziert werden, was sich positiv auf die Kosten und auf die Rohstoffabhängigkeit auswirkt. Darüber hinaus stellt beispielsweise Ruthenium bei einem Ru-Ti-Oxid die instabile Komponente dar. Wenn Ruthenium einen Rutheniumnachbarn hat, kommt es zur Wasseroxidation und der damit verbundenen Saustoffevolution, was eine rapide Auflösung des Rutheniums nach sich zieht. Vereinzelte Rutheniumatome als Dotierungen der Rutil-Oberfläche in beispielsweise Titanoxid können die Sauerstoffentwicklung, die sie auflöst, wiederum nicht katalysieren und sind daher vor der Auflösung geschützt. Mit dem im Vergleich zum Stand der Technik geringen Rutheniumgehalt, der bei dem erfindungsgemäßen Schichtverbund gewählt werden kann, gibt es auch weniger Rutheniumnachbarn, wodurch sich die intrinsische Stabilität des Mischmetalloxids verbessert. Durch die bedeckende und nicht-poröse Schicht kann der Schichtverbund in sauerstoffhaltiger Atmosphäre oxidiert werden, ohne dass Sauerstoff direkt zu einer schwach elektrisch leitenden Titanoxid-Zwischenschicht zwischen der ersten Schicht und der Oxidschicht führt. Jedoch können durch diesen Oxidationsprozess etwaige Fehlstellen der Oxidbeschichtung oxidiert werden. Dabei ist eine Titan aufweisende oder aus Titan bestehende erste Schicht von Vorteil, die Titanoxid in der Rutilphase ausbilden kann. Dieses Titanoxid ist gegenüber der elektrochemischen Korrosion in der Anwendung beständig. Im Gegensatz dazu führen die aus dem Stand der Technik bekannten, elektrochemisch geformten Oxide, die durch ihre Inhomogenität sowie teils amorphe Strukturen und Porösität stetig wachsen, zu einer Unterwanderung der Oxidschicht. Analoges gilt auch für andere Elemente der Platinmetallgruppe, beispielsweise für Iridium. Ein erfindungsgemäßer Schichtverbund lässt sich insbesondere mit einem nachfolgend noch näher beschriebenen erfindungsgemäßen Verfahren herstellen.

Vorteilhaft weist die Oxidschicht Elemente aus der Platinmetallgruppe mit einem Gehalt von <30 at% auf, insbesondere von <15 at%.

Die Oxidschicht weist bevorzugt eine Schichtdicke zwischen 1 und 10.000nm auf, insbesondere eine Schichtdicke zwischen 10 und 500nm.

Gemäß einer Ausgestaltung der vorliegenden Erfindung ist auf der Oxidschicht eine poröse Oxidschicht angeordnet, insbesondere eine poröse TiO2-Schicht mit Dotierungen zumindest eines Elementes aus der Platinmetallgruppe, insbesondere Ruthenium und/oder Iridium, sowie Kristalliten der Platinmetallgruppen-Oxide.

Bevorzugt ist die Oxidschicht unmittelbar auf der ersten Schicht angeordnet, wodurch sich ein einfacher und preiswert herzustellender Aufbau ergibt.

Alternativ ist zwischen der ersten Schicht und der Oxidschicht eine Zwischenschicht angeordnet, welche die metallischen Komponente der ersten Schicht und das Element aus der Platinmetallgruppe der Oxidschicht aufweist.

Ferner schafft die vorliegende Erfindung eine Anode für elektrochemische Oxidationsprozesse, dadurch gekennzeichnet, dass diese einen erfindungsgemäßen Schichtverbund aufweist oder aus einem solchen besteht.

Darüber hinaus schafft die vorliegende Erfindung ein Verfahren zum Herstellen eines erfindungsgemäßen Schichtverbunds, umfassend die Schritte: Auftragen einer Schicht zumindest eines Elementes aus der Platinmetallgruppe, insbesondere einer Ruthenium- und/oder Iridiumschicht, auf eine elektrisch leitende erste Schicht, die Titan aufweist oder aus Titan besteht, bevorzugt unter Einsatz eines PVD-Verfahrens, eines CVD-Verfahrens oder eines elektrochemischen Elektrodepositionsverfahrens, Glühen der Anordnung in einem Ofen in einer Schutzgasatmosphäre, insbesondere bei einer Temperatur von zumindest 600°C, besser noch bei einer Temperatur von zumindest 900°C, und Oxidieren der durch Glühen erzeugten Legierungsschicht in einem Ofen unter Erzeugung der Oxidschicht.

Ein alternatives erfindungsgemäßes Verfahren zum Herstellen eines erfindungsgemäßen Schichtverbunds umfasst die Schritte: Auftragen einer zumindest ein Element aus der Platinmetallgruppe, insbesondere Ruthenium und/oder Iridium, und Titan aufweisenden Legierungsschicht auf eine elektrisch leitfähige erste Schicht, die zumindest eine elektrisch leitende Metallkomponente aufweist oder aus dieser besteht, insbesondere Titan, und Oxidieren der Legierungsschicht in einem Ofen unter Erzeugung der Oxidschicht. Durch das direkte Auftragen der Legierungsschicht entfällt der Schritt des Glühens des zuvor beschriebenen Verfahrens.

Die Legierungsschicht wird bevorzugt unter Einsatz eines PVD-Verfahrens, insbesondere eines Cosputter-Verfahrens, eines CVD-Verfahrens oder eines elektrochemischen Elektrodepositionsverfahrens aufgetragen. Im Falle eine Cosputterns kann ein Ruthenium- und ein Titantarget verwendet werden. Ebenso ist es aber auch möglich, ein Ruthenium-Titan-Legierungstarget zu verwenden.

Das Oxidieren wird bevorzugt bei einer Temperatur von zumindest 600°C durchgeführt.

Noch ein weiteres alternatives erfindungsgemäßes Verfahren zum Herstellen eines erfindungsgemäßen Schichtverbunds weist die Schritte auf: Auftragen einer zumindest ein Element aus der Platinmetallgruppe, insbesondere Ruthenium und/oder Iridium, und Titan aufweisenden Legierungsschicht auf eine elektrisch leitfähige erste Schicht, die zumindest eine elektrisch leitende Metallkomponente aufweist oder aus dieser besteht, insbesondere Titan, unter Anwesenheit von Sauerstoff unter Erzeugung der Oxidschicht. Bei einem solchen auch als " active Sputtering" bezeichneten Auftragen wird entsprechend sofort die Ruthenium-Titan-Oxidschicht mit der RuO2-dotierten TiO2-Basisstruktur in der kristallographischen Rutil-Phase erzeugt, so dass auf einen separaten Oxidationsschritt verzichtet werden kann. Beim active Sputtering kann ein Ruthenium- und ein Titantarget verwendet werden. Ebenso ist es aber auch möglich, ein Ruthenium-Titan-Legierungstarget zu verwenden.

Noch ein weiteres alternatives erfindungsgemäßes Verfahren zum Herstellen eines erfindungsgemäßen Schichtverbunds weist die Schritte auf: Auftragen einer Legierungsschicht auf ein Trägermaterial, insbesondere in Form einer keramischen Platte, wobei die Legierungsschicht eine elektrisch leitende Metallkomponente, insbesondere Titan, und zumindest ein Element aus der Platinmetallgruppe aufweist, insbesondere unter Einsatz eines PVD-Verfahrens, insbesondere eines Cosputter-Verfahrens, eines CVD-Verfahrens oder eines elektrochemischen Elektrodepositionsverfahrens, thermisches Oxidieren der Legierungsschicht unter Ausbildung einer Oxidschicht, Auftragen einer elektrisch leitenden ersten Schicht auf die Oxidschicht, insbesondere in Form einer Titanschicht, und Entfernern des Trägermaterials, insbesondere unter Einsatz eines Ätzverfahrens, wodurch die funktionelle Schicht freigelegt wird. So kann Aluminiumoxid-Platte mit Säuren/Basen geätzt werden.

Weitere Merkmale und Vorteile der vorliegenden Erfindung werden anhand der nachfolgenden Beschreibung unter Bezugnahme auf die beiliegende Zeichnung deutlich. Darin ist
Figur 1 eine schematische Ansicht eines im Rahmen einer Vorversuchsreihe durchgeführten Verfahrens zur Herstellung eines Schichtverbunds;
Figur 2 eine Tabelle, die Präparationsparameter von Proben zeigt;
Figur 3 Röntgenbeugungs-Muster der Proben nach einem Legieren der Proben in Inertgas;
Figur 4 Röntgenbeugungs-Muster der Proben nach einem Oxidieren der legierten Proben;
Figur 5 eine SEM-Aufnahme der Probe SP_15_900_900;
Figur 6 eine vergrößerte SEM-Aufnahme der Probe SP_15_900_900;
Figur 7 eine SEM-EDX-Aufnahme der Probe SP_15_900_900 analog zu Figur 6;
Figur 8 eine SEM-Aufnahme der Probe SP_10_1200_900;
Figur 9 eine vergrößerte SEM-Aufnahme der Probe SP_10_1200_900;
Figur 10 eine SEM-EDX-Aufnahme der Probe SP_10_1200_900 analog zu Figur 9;
Figur 11 eine SEM-Aufnahme einer mit Salzsynthese hergestellten Probe DSA 500°C;
Figur 12 eine verkleinerte SEM-EDX-Aufnahme der in Figur 11 gezeigten Probe DSA 500°C;
Figur 13 eine schematische Ansicht eines Verfahrens gemäß einer Ausführungsform der vorliegenden Erfindung, das zur Herstellung eines Schichtverbunds gemäß einer Ausführungsform der vorliegenden Erfindung eingesetzt wurde;
Figur 14 ein Diagramm, das die Ruthenium-Oberflächenkonzentration in Abhängigkeit von der Glühtemperatur zeigt;
Figur 15 Röntgenbeugungs-Muster verschiedener Proben und;
Figur 16 ein Diagramm, das die Informationstiefe bei 90% Absorption in Abhängigkeit von dem Einfallswinkel zeigt.

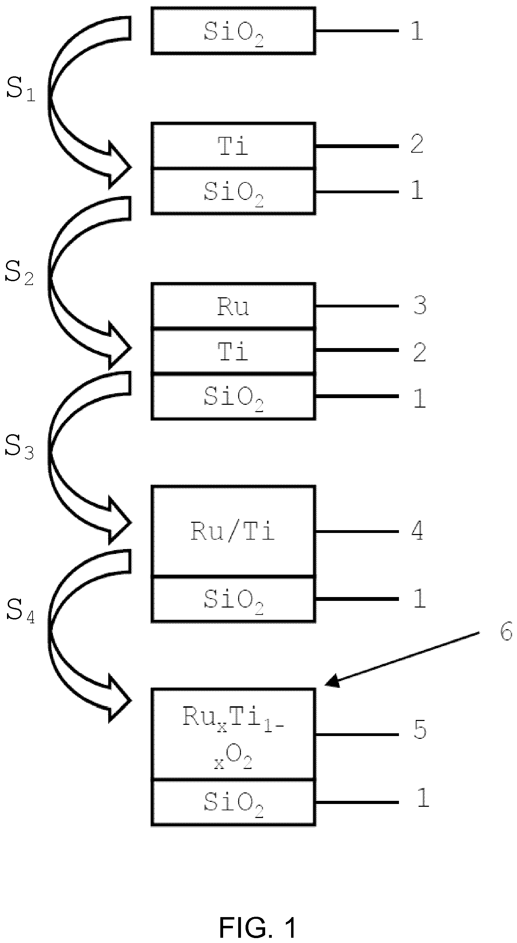

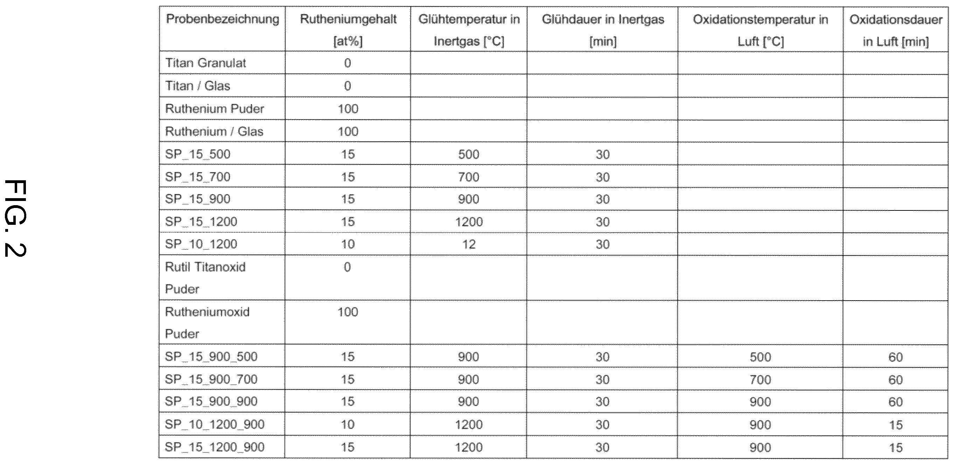

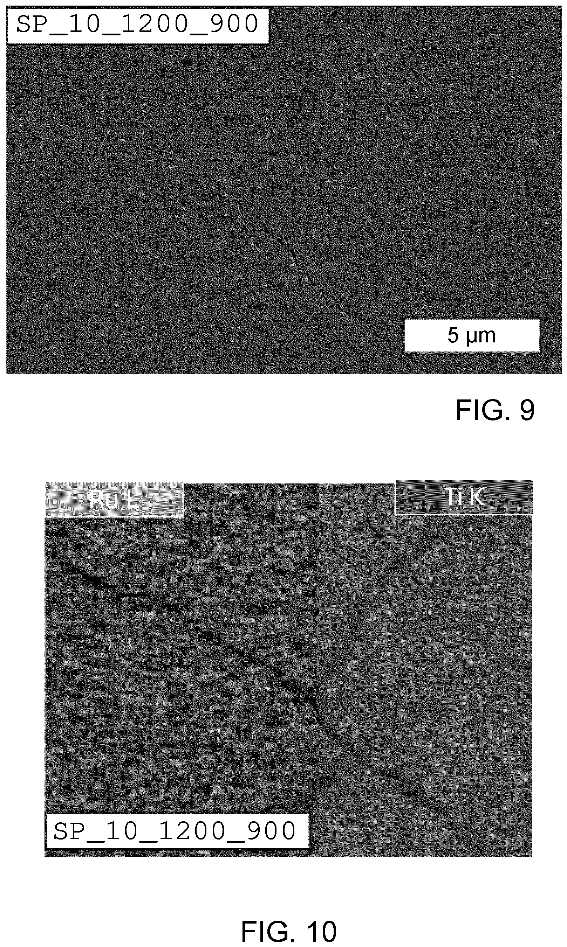

Nachfolgend wird unter Bezugnahme auf die Figuren 1 bis 12 eine erste Vorversuchsreihe beschrieben. Im Rahmen dieser Vorversuchsreihe wurden 14 mm x 2 mm große C7980-Quarzglasscheiben 1 als Substrate eingesetzt. Die Glassubstrate bildeten hier einen Modellträger, um die in weiteren Schritten geformten Schichten isoliert betrachten zu können. Dieser Aufbau wurde für rein wissenschaftliche Zwecke gewählt, um die kristallographischen Phasen und Leitfähigkeiten der thermisch legierten und darauffolgend oxidierten Schichten zu untersuchen. In einem ersten Schritt S1 wurden die Quarzglasscheiben 1 mit einer 1 µm dicken Titanschicht 2 besputtert, siehe Figur 1. In einem weiteren Schritt S2 wurde auf die Titanschicht 2 eine Rutheniumschicht 3 mit einer Dicke gesputtert, die derart gewählt war, dass eine im nachfolgenden Schritt S3 im Rahmen einer Glühbehandlung erzeugte Legierung einen gewünschten Rutheniumgehalt von 10 at% oder 15 at% aufwies. Für das Metallsputtern wurde das Quorum Q150 ES mit einem 99,99 % reinen Titan-Target (HMW Hauner GmbH&Co) und einem 99,95 % reinen Ruthenium-Target (MaTecK Material Technologie & Kristalle GmbH) verwendet. Daraufhin wurden die gesputterten Schichten 2 und 3 in Schritt S3 durch Glühen in einem Induktionsofen unter Argonfluss bei Temperaturen von 500°C, 700°C, 900°C oder 1200°C legiert. Die Legierungsschicht ist mit der Bezugsziffer 4 gekennzeichnet. Um eine Kontamination mit Sauerstoff zu vermeiden, wurde der Heizraum vor dem Glühvorgang dreimal evakuiert und mit Argon gespült. Der Argonfluss wurde dann so reguliert, dass der Druck im Heizraum bei 1 bar gehalten wurde. Die Proben wurden mit einer Heizrampe von 0,2 °C/s geglüht, bis die gewünschte Temperatur erreicht war, und 30 Minuten lang auf dieser Temperatur gehalten. Anschließend wurde die Heizkammer durch Argonfluss abgekühlt. In einem weiteren Schritt S4 wurde eine Oxidation in einem Muffelofen (Nabertherm) bei unterschiedlichen Oxidationstemperaturen von 500°C, 700°C und 900°C für unterschiedliche Oxidationsdauern von 15 min oder 1h durchgeführt. Die durch die Oxidation erzeugte Ruthenium-Titan-Oxidschicht ist in Figur 1 mit der Bezugsziffer 5 versehen, der gesamte Schichtverbund mit der Bezugsziffer 6. Die detaillierten Präparationsparameter für jede gesputterte Probe sind in Figur 2 aufgeführt.

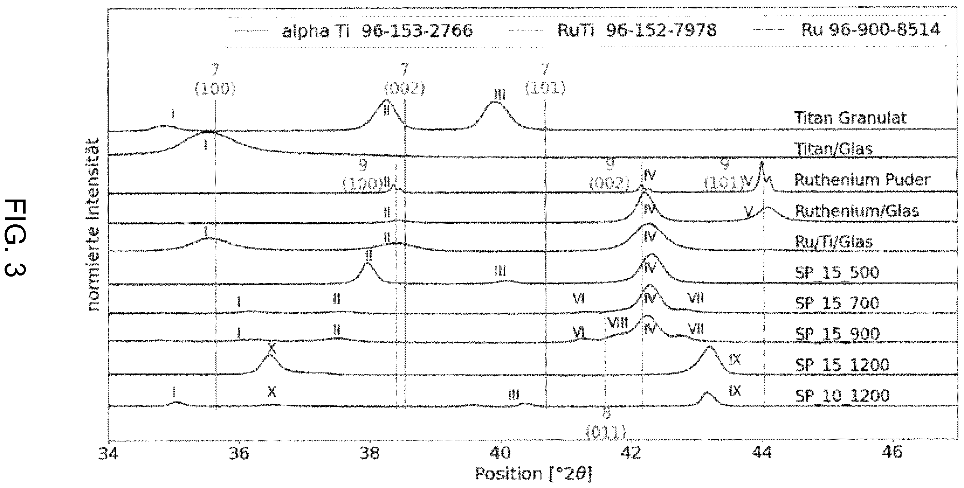

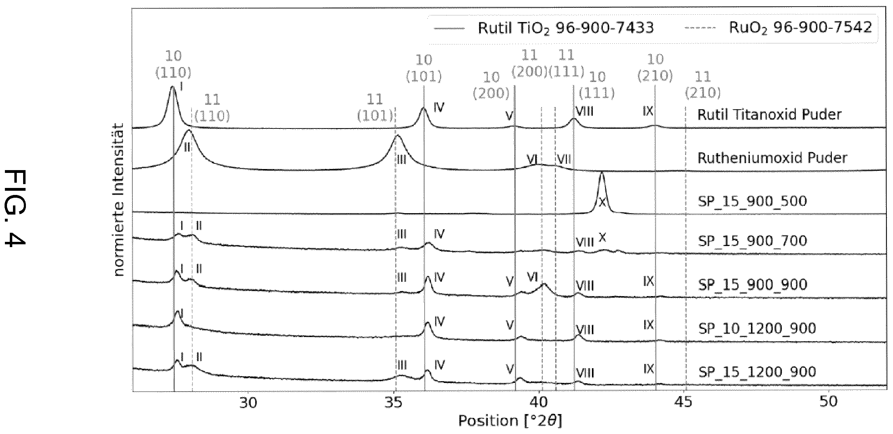

Die Figuren 3 und 4 zeigen Röntgenbeugungs (XRD)-Muster der Proben, Figur 3 nach dem Legieren der Proben und Figur 4 nach dem sich anschließenden Oxidieren der Proben. Die Röntgenbeugungsmuster wurden mit einem Empyrean-Diffraktometer von Malvern Panalytical aufgezeichnet. Das Diffraktometer wurde mit einer Bragg-Brentano-High-Definition-Optik (BBHD) und einer Optik für streifenden Einfall (GI) betrieben. Die BBHD-Optik wurde zur Analyse der Masse und die Gl-Optik zur Untersuchung der Grenzfläche der gesputterten Schichten der Beschichtung verwendet. Leitfähigkeitsmessungen wurden mit einem Vier-Terminal-Sondenkopf (PSR RMH504) von Nittoseiko Analytech durchgeführt, der an einen PGSTAT101-Potentiostaten von Metrohm angeschlossen war. Alle Peak-Positionen der Muster wurden mit den Peak-Positionen der Muster der entsprechenden Materialien aus der COD (Christallography Open Database)-Datenbank verglichen. Letztere sind in den Figuren 3 und 4 durch vertikale Linien angezeigt, wobei die vertikalen Linien für α -Ti 96-153-2766 mit der Bezugsziffer 7, die vertikalen Linien für RuTi 96-152-7978 mit der Bezugsziffer 8, die vertikalen Linien für Ru 96-900-8514 mit der Bezugsziffer 9, die vertikalen Linien für rutile TiO2 96-900-7433 mit der Bezugsziffer 10 und die vertikalen Linien für RuO2 96-900-7542 mit der Bezugsziffer 11 gekennzeichnet sind.

In Figur 3 sind die Ergebnisse von Titangranulat ("Ti granulate") und Rutheniumpulver (" Ru powder") als Referenz angezeigt. Außerdem sind Muster von 1 µm dicken Schichten aus Titan ("Ti/glass") und Ruthenium ("Ru/glass) enthalten, die auf Glas (SiO2) gesputtert wurden, um die Phasenzusammensetzung und -umwandlung nach dem Metallsputtern und nach dem Glühen in einer Inertgasatmosphäre bei verschiedenen Temperaturen zu verfolgen.

Das Muster des Titangranulats ("Ti granulate") zeigt drei Peaks, die in Figur 3 als I, II und III gekennzeichnet sind. Im Vergleich zu den Mustern aus der COD-Datenbank entsprechen diese der (100)-, (002)- und (101)-Orientierung der α -Titanphase, sind aber bis zu 0,5° nach links verschoben. Die Peaks der (002)- und (101)-Orientierung weisen die gleiche Intensität auf, während die (100)-Orientierung eine schwächere Intensität aufweist. Die auf Glas gesputterte 1-µm-Titanschicht ("Ti/glass") zeigt nur die (100)-Orientierung der α -Titanphase (als I angegeben), was gut übereinstimmt. Das Muster des Rutheniumpulvers ("Ru powder") zeigt ebenfalls drei ausgeprägte Peaks, die als II, IV und V bezeichnet werden. Alle drei Peaks zeigen einen Doppelpeak, was auf die Cu Kα 2-Strahlung zurückzuführen ist. Diese Peaks entsprechen gut der (100)-, (002)- und (101)-Orientierung der Rutheniumphase. Der Peak, welcher der (101)-Orientierung entspricht, zeigt die höchste Intensität, während die beiden anderen die gleiche, aber geringere Intensität aufweisen. Das Muster der 1 µm dicken Rutheniumschicht ("Ru/glass"), die auf Glas gesputtert wurde, zeigt ebenfalls drei Peaks bei denselben Winkelpositionen, jedoch mit einer Peakverbreiterung. Darüber hinaus weist der IV-Peak, der dem (002) entspricht, im Vergleich zum II- und V-Peak eine höhere Intensität auf. Das Muster der Probe ("Ru/Ti/glass") mit einer 135 nm dicken Rutheniumschicht, die auf eine 1 µm dicken Titanschicht gesputtert wurde, die wiederum auf Glas gesputtert wurde (entspricht 15 at% Ruthenium in der Beschichtung), zeigt drei Peaks. In Bezug auf die zuvor besprochenen Muster, insbesondere die auf Glas gesputterten Ruthenium- und Titanschichten ("Ru/glass" und "Ti/glass"), entsprechen diese drei Peaks der (100)-Orientierung der α -Titanphase, siehe Bezugsziffer 7, und der (100)-sowie (002)- Orientierung der Rutheniumphase, siehe die Bezugsziffern 9. Hier hat der Peak, der der (002)-Orientierung entspricht, auch die höchste Intensität, während die Peaks, die der (100)-Orientierung der Titanphase und der (100)-Orientierung der Rutheniumphase entsprechen, die gleiche Intensität aufweisen. Der Peak V, welcher der (101)-orientierung der Rutheniumphase entspricht, ist nicht sichtbar. Die als II bezeichneten Peaks entsprechen also der (100)-Phase von Ruthenium und nicht der (002)-Titanphase, da in den Mustern der aufeinander gesputterten Schichten nur die (001)-Orientierung beobachtet werden kann. Im Muster der Probe SP_15_500, bei der der Glas-Titan-Ruthenium-Schichtverbund bei 500°C in Inertgas legiert wurde, können nur die Peaks II, III und IV beobachtet werden. Im Gegensatz zur aufeinander gesputterten Probe (Ru/Ti/Glas) kann der Peak I nicht beobachtet werden, wohl aber der Peak III. Der Peak III entspricht der α -Titanphase, ist jedoch um etwa 0,6° nach links verschoben, ähnlich wie bei dem Muster, das vom Titangranulat stammt. Die Peaks II und IV entsprechen der Rutheniumphase, wobei Peak II um etwa 0,4° nach links und Peak IV um etwa 0,2° nach rechts verschoben ist. Peak IV weist die höchste Intensität auf, gefolgt von Peak II. Die Intensität von Peak III ist im Vergleich zu den als II und IV angegebenen Peaks gering. Im Muster der Probe SP_15_700, welche bei 700°C legiert wurde, ist zu erkennen, dass sich die Peaks I und II zueinander verschieben. Der Peak I ist um 0,5° nach rechts von der (100)-Orientierung der Titanphase verschoben und Peak II ist um etwa 0,8° nach links von der (002)-Orientierung des Rutheniums verschoben. Während der Peak IV der (002)-Orientierung entspricht und ebenfalls um 0,2° nach rechts verschoben ist, wie im vorherigen Muster besprochen. Es können jedoch zwei neue Peaks neben dem IV-Peak beobachtet werden. Einer auf der linken Basis (VI) des IV-Peaks und einer auf der rechten Seite (VII). Der Peak IV weist im Vergleich zu allen anderen Peaks im Muster die höchste Intensität auf. Das von der Probe SP_15_900 aufgezeichnete Muster zeigt eine ähnliche Peakstruktur, jedoch mit einem weiteren neuen Peak, der als VIII angegeben ist. Dieser Peak kann der Ruthenium-Titan-Mischphase zugeordnet werden und bildet eine Schulter links neben dem als IV angegebenen Peak. Alle Peaks um den IV-Peak sind daher Beiträge von Gitterrelaxationen aufgrund der Vermischung beider Metalle. Das von SP_15_1200 aufgezeichnete Muster zeigt nur zwei Peaks. Beide Peaks können keiner der angegebenen Referenzspektren zugeordnet werden, was auf eine starke Gitterverzerrung zurückzuführen ist, oder auf ein Gitter einer nicht bekannten Mischstruktur beider Kristalle. Die Probe SP_10_1200 zeigt neben den Peakpositionen der SP_15_1200 noch die Peaks I und III, welche Titankristalliten zugeordnet werden. Es ist in dieser Probe nicht genügend Ruthenium vorhanden, um das gesamte vorhandene Titan in eine neue Kristallstruktur zu drängen.

Daraus folgt, dass es bei Glühtemperaturen über 900 °C aufgrund der Vermischung der Metalle zu einer signifikanten Legierung beider Metalle kommt. Dies wird durch die mehreren Phasen, die im Muster der Probe SP_15_900 beobachtet werden, und die vollständige Phasenumwandlung, die im Muster von SP_15_1200 beobachtet wird, deutlich.

In Figur 4 sind die Muster der Proben nach der Oxidation dargestellt. Als Referenz wurden Muster eines Rutil-Titanoxid-Pulvers ("rutile TiO2 powder") und eines Rutheniumoxid-Pulvers ("RuO2 powder") aufgezeichnet. Im Muster des Rutil-Titanoxid-Pulvers entsprechen die als I, IV, V, VIII und IX angegebenen Peaks den Orientierungen (110), (101), (200), (111) und (210) des Rutil-Titanoxidmusters der COD-Datenbank, siehe die Bezugsziffern 10. Die Peaks II, III, VI und VII entsprechen der (110)-, (101)-, (200)- und
(111)-Orientierung des Rutheniumoxid-Musters der COD-Datenbank, siehe die Bezugsziffern 11. Peak II ist im Vergleich zum COD-Referenzmuster um 0,1° nach links verschoben und Peak III um 0,1° nach rechts. Im Muster der Probe SP_15_900_500 kann nur Peak X beobachtet werden. Dieser Peak ist derselbe wie der in den Mustern in Figur 3 als IV angegebene und entspricht somit der Ruthenium (002)-Orientierung. Im Muster der Probe SP_15_900_700 können die Peaks I, II, III, IV und VII alle der Ruthenium- und Titanoxidphase zugeordnet werden. Nur die als X gekennzeichneten Peaks weisen auf Restmetallphasen in der Beschichtung hin, ähnlich wie die Peaks, die um Peak IV im Muster der Probe SP_15_900 beobachtet wurden. Im Muster der Probe SP_15_900_900 können nur Peaks beobachtet werden, die den Ruthenium- und Titanoxidphasen entsprechen. Außerdem hat die Intensität der den Oxidphasen entsprechenden Peaks zugenommen. Die Peaks der Titanoxidphase haben sich in Richtung der Peaks des Rutheniumoxides verschoben, welches durch die Gitterverzerrung der Ruthenium-Dotierung der Titanoxidphase zu begründen ist. Bei der SP_15_1200_900 Probe ist die Löslichkeit der des Rutheniumoxid in der Titanoxid überschritten, so dass das Rutheniumoxid partiell nicht mit der TiO2-Rutilstruktur mischt oder entmischt, weshalb reine RuO2-Nanokristalle entstanden sind. Das Muster der Probe SP_10_1200_900 zeigt nur Peaks der Titanoxidphase, welche in Richtung der Rutheniumoxid-Peaks verschoben sind, was durch eine phasenreine Dotierung der Titanoxidphase zu erklären ist.

Beim Vergleich der bei 900 und 1200 °C geglühten Proben wird deutlich, dass vorige Legierung vorteilhaft für die Ausbildung eine RuO2-dotierten TiO2-Rutil-Basisstruktur ist. Zusammenfassend kann festgestellt werden, dass bei optimaler Dotierung der RuO2 110-Peak, der bei 28,07 positioniert ist, verschwindet und sich der TiO2 110-Peak, der bei 27,434 positioniert ist, nach rechts verschiebt, siehe hierzu die Proben SP2_10_1200_900 und SP3_10_1200_900. Dies liegt daran, dass die Raumverzerrung dazu führt, dass sich beide Peaks ein stückweit in der Mitte in einer gemeinsamen Struktur treffen. Bei einer nicht ganz idealen Vermischungen bleibt der RuO2-Peak durch phasenreine Kristallite erhalten, während sich der TiO2-Peak durch die RuO2-Dotierung geringfügig nach rechts verschiebt.

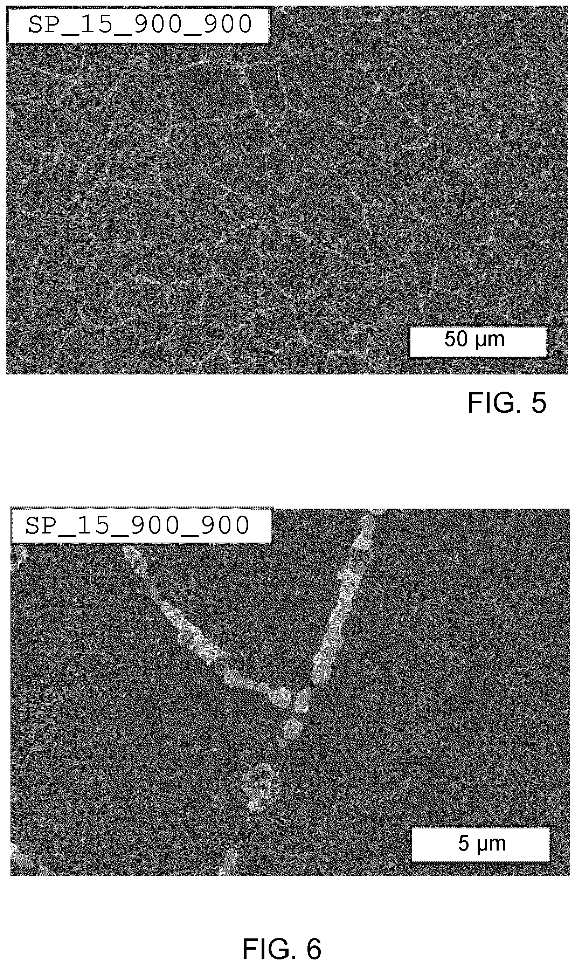

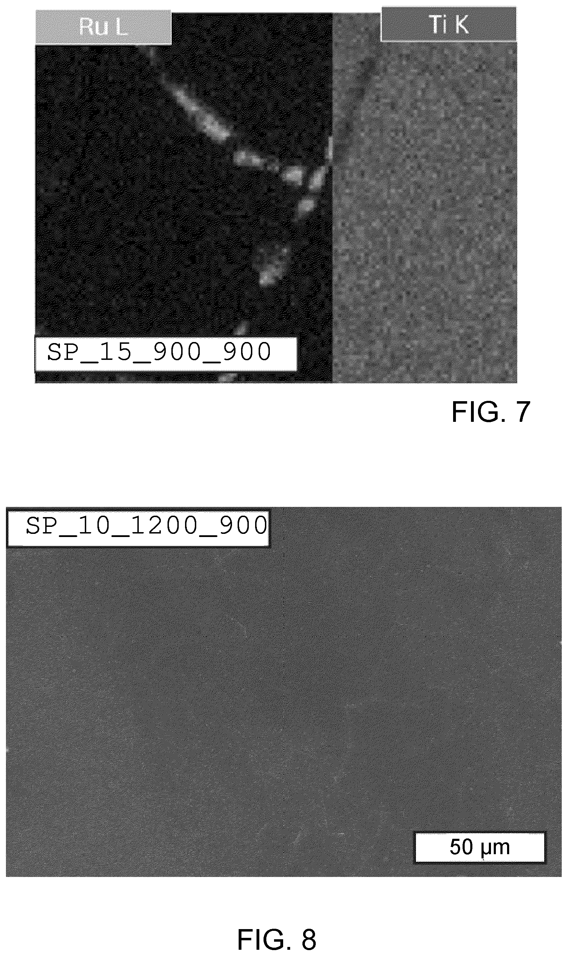

Ferner wurden SEM ("Scanning Electron Microscope)- und EDX (" Energy Dispersive X-ray spectroscopy") -Bilder geglühter und oxidierter Proben erstellt. Die Figuren 5 bis 7 zeigen Aufnahmen der SP_15_900_900 Probe. Die Figuren 5 und 6 zeigen SEM-Aufnahmen der Probe bei unterschiedlicher Vergrößerung, die eine geschlossene aber inhomogene Beschichtung aufweisen. Bei den EDX-Daten von Figur 7 zeigt sich, dass sich eine rutheniumreiche Phase bildet, die unterschiedliche Ti- und Ru-haltige Phasen voneinander trennen. Für die Anwendung wird erwartet, dass die Ausblühungen dieser RuO2-Phasen, wie sie auch schon in den XRD-Daten von Figur 4 gezeigt wurden, unvorteilhaft sind. Die Figuren 8, 9 und 10 zeigen SEM- und EDX-Aufnahmen der SP_10_1200_900 Probe, die eine geschlossene Schicht zeigen, in der keine lokalen Ansammlungen der Elemente beobachtet werden konnten, was für die Langlebigkeit der Beschichtung vorteilhaft ist.

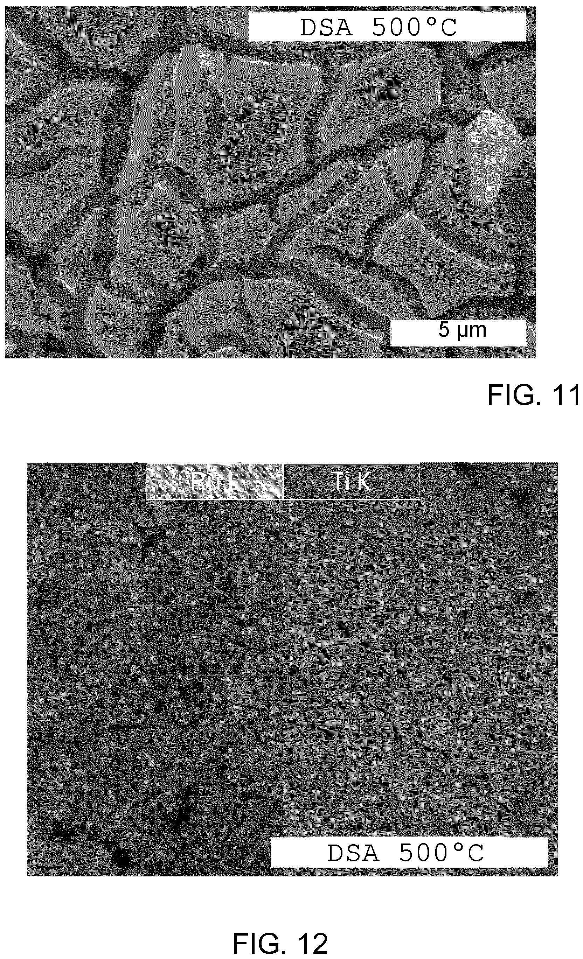

Die Figuren 11 und 12 zeigen Aufnahmen einer Probe DAS 500°C, die mit Salzsynthese hergestellt wurde, als exemplarisches Beispiel einer gemäß Stand der Technik hergestellten dimensionsstabilen Anode für die Chlorgasevolution. Für die Salzsynthese wurden vorliegend zwei Stammlösungen hergestellt. Jeweils 0,1 M TiCl4 und RuCl3 wurden in Isopropanol gelöst. Jede nachfolgende Lösung wurde aus diesen Stammlösungen hergestellt, indem beide Lösungen im gewünschten Verhältnis kombiniert wurden. Die Beschichtung wurde durch Auftropfen von 40 µl einer Salzlösung auf das Substrat aufgebracht, das auf einer Heizplatte bei 60 °C ruhte. Die Lösung wurde zwei Minuten lang getrocknet, nachdem der nächste Tropfen aufgetragen wurde. Dies wurde dreimal durchgeführt. Anschließend wurde die Probe zum Kalzinieren in einen Ofen (Vevor) bei einer Temperatur von 500°C überführt. Daraufhin wurde jeglicher Überschuss mit einem Pinsel entfernt, um eine glatte Oberfläche zu erhalten. Der gesamte Prozess wurde fünfmal wiederholt, um eine ausreichende Beschichtung des Glassubstrats zu erzielen. Die Probe zeigt eine poröse und grabenreiche Struktur, die auch als "Schlammrissoberfläche" bezeichnet wird, typisch für die Herstellung mittels Salzsynthese ist und das metallische Substrat nur teilweise vor Korrosion schützen kann.

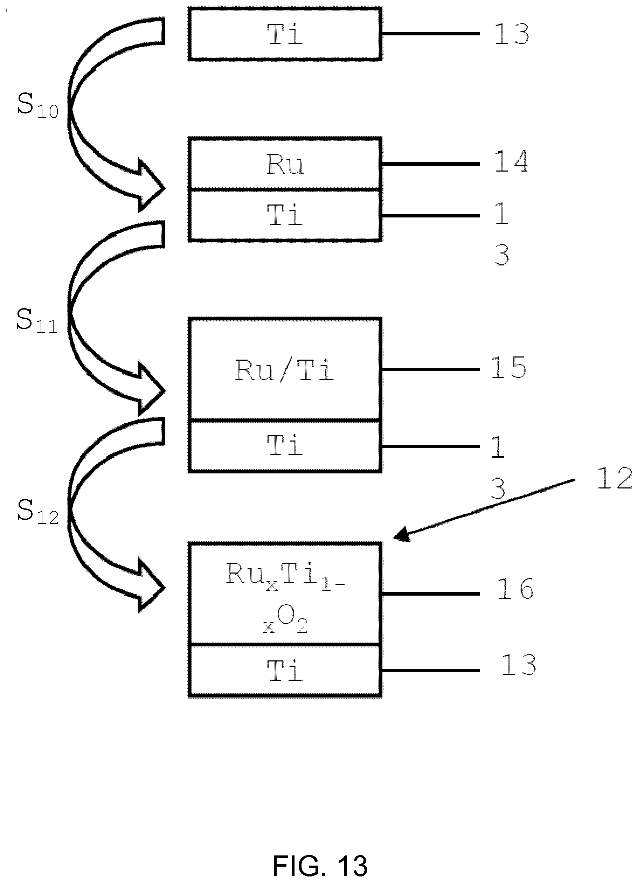

Nachfolgend wird unter Bezugnahme auf die Figuren 13 bis 15 eine Versuchsreihe beschrieben. Im Rahmen dieser Versuchsreihe wurden, wie es in Figur 13 gezeigt ist, zur Herstellung eines Schichtverbunds 12 gemäß einer Ausführungsform der vorliegenden Erfindung erste Schichten 13 in Form von 2 mm dicken Titanschichten 13, die als elektrisch leitfähige Substrate dienten, in einem ersten Schritt S10 mit einer Schicht 14 eines Elementes aus der Platinmetallgruppe besputtert, vorliegend mit einer 50nm dicken Rutheniumschicht 14. Für das Metallsputtern wurde das Quorum Q150 ES mit einem 99,95 % reinen Ruthenium-Target (MaTecK Material Technologie & Kristalle GmbH) verwendet. Daraufhin wurden die Anordnungen in einem sich anschließenden Schritt S11 durch Glühen in einem Induktionsofen unter Argonfluss bei Temperaturen zwischen 500°C, 600°C und 700°C geglüht. Die durch das Glühen entstehende Legierungsschicht trägt die Bezugsziffer 15. Um eine Kontamination mit Sauerstoff zu vermeiden, wurde der Heizraum vor dem Glühvorgang dreimal evakuiert und mit Argon gespült. Der Argonfluss wurde dann so reguliert, dass der Druck im Heizraum bei 1 bar gehalten wurde. Die Probe wurden mit einer Heizrampe von 0,2 °C/s geglüht, bis die gewünschte Temperatur erreicht war, und 15 bzw. 30 Minuten lang auf dieser Temperatur gehalten. Anschließend wurde die Heizkammer durch Argonfluss abgekühlt. In einem weiteren Schritt S12 wurde eine Oxidation in einem Muffelofen (Nabertherm) bei einer Oxidationstemperatur von 700°C für eine Oxidationsdauer von 60 min durchgeführt. Die durch die Oxidation erzeugte, als Gradientenlegierung ("Gradient Alloy") ausgebildete Oxidschicht, vorliegend die Ruthenium-Titan-Oxidschicht, ist in Figur 13 mit der Bezugsziffer 16 versehen.

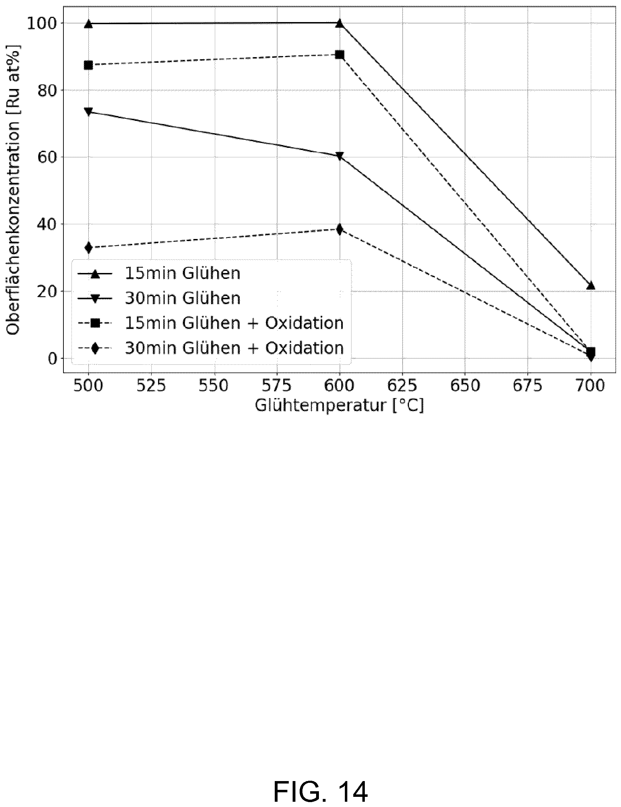

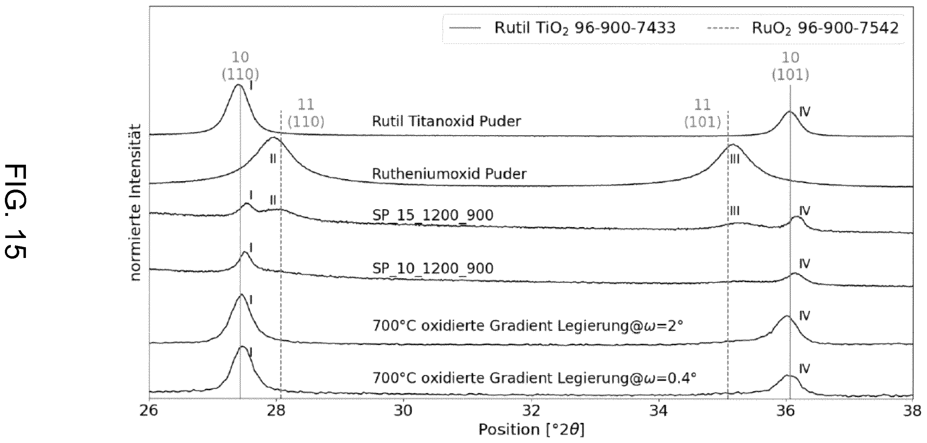

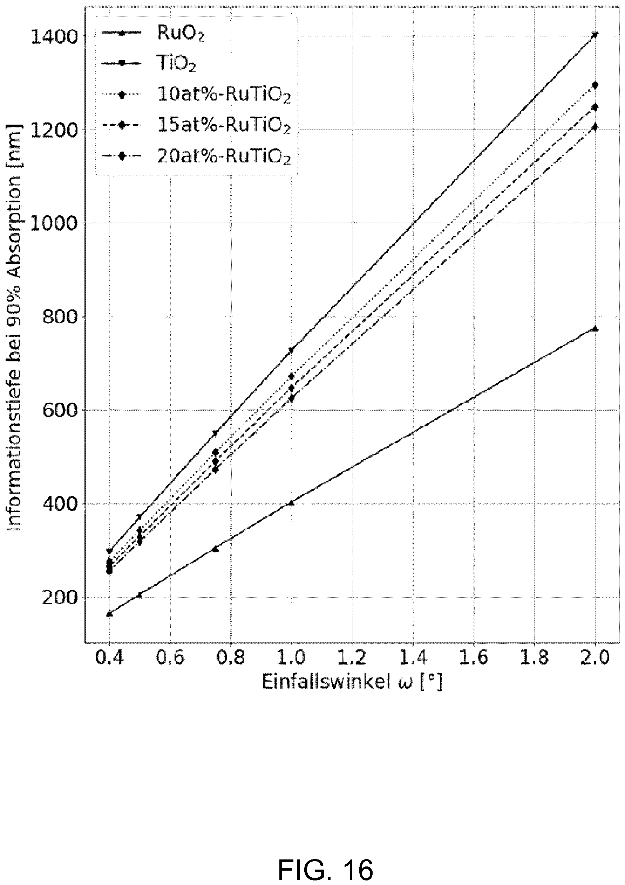

Figur 14 zeigt den Rutheniumgehalt in at% an der Oberfläche der Proben vor und nach dem Oxidieren. Hierbei ist die Eindringtiefe der Röntgenstrahlung bei der EDX-Messung zu berücksichtigen, die auch zu der Messung von Atomen unterhalb der Oberfläche führt. Die Probe bei 700°C zeigt einen deutlichen Abfall der Ausgangskonzentrationen von Ruthenium, was durch dessen Diffusion in das Titan-Substrat zu begründen ist. Figur 15 zeigt das XRD-Muster der bei 700°C legierten und darauffolgend oxidierten Gradientlegierung (" 700°C Gradient Alloy"). Weiterhin sind die Diffraktogramme des Modellsystems auf dem Glasträger zum Vergleich gezeigt, welche unter Bezugnahme auf die Figuren 1 bis 4 eingehend untersucht wurde. Um oberflächennahe Strukturanalysen durchzuführen, wurden niedrige Einfallswinkel ω verwendet, nämlich 2° auf 0,4°. Dabei entspricht der Einfallswinkel ω =0,4° einer Messtiefe von etwa 260nm und der Einfallswinkel ω = 2° einer Messtiefe von etwa 1200nm bei jeweils 90% Absorption, siehe Figur 16. Ähnlich zu dem Modellsystem SP_10_1200_900 sind ausschließlich TiO2 Peaks zu sehen, die sich zu denen der RuO2-Phasen verschieben, was auf eine RuO2-Dotierung der TiO2-Schichten hinweist. Durch Variation der Ruthenium-Schichtdicke, der Glühtemperatur und der Oxidationstemperatur können die Ruthenium- und Sauerstoffgradienten von der Oberfläche in die vorliegend als Substrat dienende erste Schicht 13 durch einen Fachmann eingestellt werden. Der hier vorgestellte Parameterraum zeigt lediglich eine exemplarische Ausführung zur Machbarkeit des erfindungsgemäßen Schichtverbunds.

SEM- und EDX-Bilder der 700°C Gradientenlegierung zeigten analog zur Vorversuchsreihe eine geschlossene und glatte Oberfläche.

Untersuchungen der Leitfähigkeit der 700°C Gradientenlegierung ergaben, dass die Leitfähigkeit etwa der Leitfähigkeit mittels herkömmlichen Kalzinierens hergestellter Proben entspricht.

Es sollte klar sein, dass die zuvor beschriebenen Ausführungsformen lediglich als Beispiel dienen und nicht als einschränkend angesehen werden sollen. Vielmehr sind Modifikationen und Änderungen möglich, ohne den durch die beiliegenden Ansprüche definierten Schutzbereich zu verlassen. Insbesondere sei darauf hingewiesen, dass ein erfindungsgemäßer Schichtverbund alternativ auch hergestellt werden kann, indem die Rutheniumschicht und die Titanschicht nicht gesputtert sondern in anderer Weise aufgetragen werden, beispielsweise mittels Gasphasenabscheidung. Ebenso muss das elektrisch leitfähige Substrat kein Titansubstrat sein. Titan kann auch durch jedes andere elektrisch leitfähige Material ersetzt werden. In diesem Fall wird auf das Substrat zunächst eine Titanschicht aufgetragen, bevor die Rutheniumschicht aufgetragen wird. Ebenso kann ein alternatives Verfahren zur Herstellung eines erfindungsgemäßen Schichtverbunds zum Einsatz kommen, wie insbesondere ein in den Ansprüche 9, 12 oder 13 definiertes Verfahren.

## Patentansprüche

**1.** Schichtverbund (12) umfassend eine elektrisch leitende erste Schicht (13), die zumindest eine elektrisch leitende Metallkomponente aufweist oder aus dieser besteht, insbesondere Titan, und eine die erste Schicht (13) bedeckende, zumindest ein Element der Platinmetallgruppe aufweisende Oxidschicht (16), **dadurch gekennzeichnet, dass** die Oxidschicht (16) insbesondere fluiddicht ausgebildet ist und elektrisch leitfähige Bereiche aus kristallographischen Rutil-Oxidphasen aufweist, wobei die elektrisch leitfähigen Bereiche Titan als hauptsächlich vorliegende Metallkomponente mit Dotierungen von zumindest einem Platinmetallgruppenmetall, insbesondere Ruthenium und/oder Iridium, sowie Kristallite der Platinmetallgruppenmetall-Oxide umfasst.

**2.** Schichtverbund (12) nach Anspruch 1, **dadurch gekennzeichnet, dass** die Oxidschicht (16) Elemente aus der Platinmetallgruppe mit einem Gehalt von <30 at% aufweist, insbesondere von <15 at%.

**3.** Schichtverbund (12) nach Anspruch 1 oder 2, **dadurch gekennzeichnet, dass** die Oxidschicht (16) eine Schichtdicke zwischen 1 und 10.000nm aufweist, insbesondere eine Schichtdicke zwischen 10 und 500nm.

**4.** Schichtverbund (12) nach einem der vorhergehenden Ansprüche, **dadurch gekennzeichnet, dass** auf der Oxidschicht (16) eine poröse Oxidschicht angeordnet ist, insbesondere eine poröse TiO2-Schicht mit Dotierungen zumindest eines Elementes aus der Platinmetallgruppe, insbesondere Ruthenium und/oder Iridium, sowie Kristalliten der Platinmetallgruppenmetall-Oxide.

**5.** Schichtverbund (12) nach einem der vorhergehenden Ansprüche, **dadurch gekennzeichnet, dass** die Oxidschicht (16) unmittelbar auf der ersten Schicht (13) angeordnet ist.

**6.** Schichtverbund (12) nach einem der Ansprüche 1 bis 4, **dadurch gekennzeichnet, dass** zwischen der ersten Schicht (13) und der Oxidschicht (16) eine Zwischenschicht angeordnet ist, welche die metallischen Komponente der ersten Schicht (13) und das Element aus der Platinmetallgruppe der Oxidschicht (16) aufweist.

**7.** Anode für elektrochemische Oxidationsprozesse, **dadurch gekennzeichnet, dass** diese einen Schichtverbund (12) nach einem der vorhergehenden Ansprüche aufweist.

**8.** Verfahren zum Herstellen eines Schichtverbunds (12) nach einem der Ansprüche 1 bis 6, umfassend die Schritte: Auftragen einer Schicht zumindest eines Elementes aus der Platinmetallgruppe, insbesondere einer Ruthenium- und/oder Iridiumschicht, auf eine elektrisch leitende erste Schicht (13), die Titan aufweist oder aus Titan besteht, bevorzugt unter Einsatz eines PVD-Verfahrens, eines CVD-Verfahrens oder eines elektrochemischen Elektrodepositionsverfahrens, Glühen der Anordnung in einem Ofen in einer Schutzgasatmosphäre, insbesondere bei einer Temperatur von zumindest 600°C, besser noch bei einer Temperatur von zumindest 900°C, und Oxidieren der durch Glühen erzeugten Legierungsschicht (15) in einem Ofen unter Erzeugung der Oxidschicht (16).

**9.** Verfahren zum Herstellen eines Schichtverbunds (12) nach einem der Ansprüche 1 bis 6, umfassend die Schritte: Auftragen einer zumindest ein Element aus der Platinmetallgruppe, insbesondere Ruthenium und/oder Iridium, und Titan aufweisenden Legierungsschicht (15) auf eine elektrisch leitfähige erste Schicht (13), die zumindest eine elektrisch leitende Metallkomponente aufweist oder aus dieser besteht, insbesondere Titan, und Oxidieren der Legierungsschicht (15) in einem Ofen unter Erzeugung der Oxidschicht (16).

**10.** Verfahren nach Anspruch 9, **dadurch gekennzeichnet, dass** die Legierungsschicht (15) unter Einsatz eines PVD-Verfahrens, insbesondere eines Cosputter-Verfahrens, eines CVD-Verfahrens oder eines elektrochemischen Elektrodepositionsverfahrens aufgetragen wird.

**11.** Verfahren nach Anspruch 8 bis 10, **dadurch gekennzeichnet, dass 12.**
das Oxidieren bei einer Temperatur von zumindest 600°C durchgeführt wird.

**13.** Verfahren zum Herstellen eines Schichtverbunds (12) nach einem der Ansprüche 1 bis 6, umfassend die Schritte: Auftragen einer zumindest ein Element aus der Platinmetallgruppe, insbesondere Ruthenium und/oder Iridium, und Titan aufweisenden Legierungsschicht (15) auf eine elektrisch leitfähige erste Schicht (13), die zumindest eine elektrisch leitende Metallkomponente aufweist oder aus dieser besteht, insbesondere Titan, unter Anwesenheit von Sauerstoff unter Erzeugung der Oxidschicht (16).

**14.** Verfahren zum Herstellen eines Schichtverbunds (12) nach einem der Ansprüche 1 bis 6, umfassend die Schritte: Auftragen einer Legierungsschicht (15) auf ein Trägermaterial, insbesondere in Form einer keramischen Platte, wobei die Legierungsschicht (15) eine elektrisch leitende Metallkomponente, insbesondere Titan, und zumindest ein Element aus der Platinmetallgruppe aufweist, insbesondere unter Einsatz eines PVD-Verfahrens, insbesondere eines Cosputter-Verfahrens, eines CVD-Verfahrens oder eines elektrochemischen Elektrodepositionsverfahrens, thermisches Oxidieren der Legierungsschicht (15) unter Ausbildung einer Oxidschicht (16), Auftragen einer elektrisch leitenden ersten Schicht (13) auf die Oxidschicht (16) und Entfernern des Trägermaterials, insbesondere unter Einsatz eines Ätzverfahrens.
